Europäisches Patentamt

European Patent Office

Office européen des brevets

(19)

(11) **EP 1 538 749 A2**

(12) **EUROPÄISCHE PATENTANMELDUNG**

(43) Veröffentlichungstag:
**08.06.2005  Patentblatt 2005/23**

(51) Int Cl.7: **H03H 17/06**

(21) Anmeldenummer: **04105577.3**

(22) Anmeldetag: **08.11.2004**

(84) Benannte Vertragsstaaten:
**AT BE BG CH CY CZ DE DK EE ES FI FR GB GR HU IE IS IT LI LU MC NL PL PT RO SE SI SK TR**
Benannte Erstreckungsstaaten:
**AL HR LT LV MK YU**

(30) Priorität: **11.11.2003  DE 10352537**

(71) Anmelder: **SIEMENS AKTIENGESELLSCHAFT**
**80333 München (DE)**

(72) Erfinder: **Vary, Peter**
**52074, Aachen (DE)**

(54)  **Verfahren und Filterbank zur spektralen Modifikation eines digitalen Signals**

(57)  Es wird ein Verfahren zur spektralen Modifikation eines digitalen Signals (x(k)) beschrieben, bei dem das Signal (x(k)) mit einem äquivalenten Zeitbereichsfilter mit einer effektiven Summenimpulsantwort gefiltert wird, indem das Signal durch eine Verzögerungskette (8, 9) mit einer Anzahl von Verzögerungsstufen (4, 5) geleitet wird und ein vor und/oder nach der Verzögerungskette (8, 9) und/oder zwischen den Verzögerungsstufen (4, 5) abgegriffener Signalanteil jeweils durch eine Filtereinheit (6) mit einer gewichteten Tiefpass-Prototyp-Impulsantwort (h(0),...,h(k),...,h(n-1)) geleitet wird und die Signalanteile anschließend wieder aufsummiert werden.

Darüber hinaus wird eine Filterbank (1) zur entsprechenden spektralen Modifikation eines digitalen Signals beschrieben.

FIG 3

EP 1 538 749 A2

**Beschreibung**

Verfahren und Filterbank zur spektralen Modifikation eines digitalen Signals

Die Erfindung betrifft ein Verfahren zur spektralen Modifikation eines digitalen Signals, insbesondere eines Audiosignals, sowie eine Filterbank zur entsprechenden spektralen Modifikation des digitalen Signals.

Verfahren zur spektralen Modifikation eines digitalen Signals werden innerhalb der modernen digitalen Signalverarbeitung für die verschiedensten Zwecke eingesetzt. Zu den typischen Anwendungsgebieten zählen u. a. digitale Mobilfunksysteme und Spracherkennungssysteme. Dabei geht es in der Regel darum, gestörte Sprachsignale mit Hilfe der digitalen Sprachsignalverarbeitung zu verbessern. So können beispielsweise zuvor ausgemessene Frequenzgänge bestimmter Ein- oder Ausgabemodule, wie des Hörers bzw. Lautsprechers eines Mobilfunkgeräts, durch entsprechende Vor- bzw. Nachfilterung des Signals ausgeglichen werden, um ein optimales Eingangs- bzw. Ausgangssignal zu erhalten. Ein typisches Ausführungsbeispiel hierfür ist ein sogenannter "Graphic Equalizer". Weiterhin können beispielsweise durch eine ständige Adaption der Filtercharakteristika an das zu modifizierende Signal ursprünglich mit dem Sprachsignal aufgenommene Hintergrundgeräusche, z. B. beim Benutzen einer Freisprecheinrichtung in einem Autotelefon, oder auch durch die Übertragung in einem Mobilfunknetz verursachte Störungen des Signals durch entsprechende spektrale Modifikation, d. h. Filterungen, eliminiert oder zumindest in starkem Maße reduziert werden.

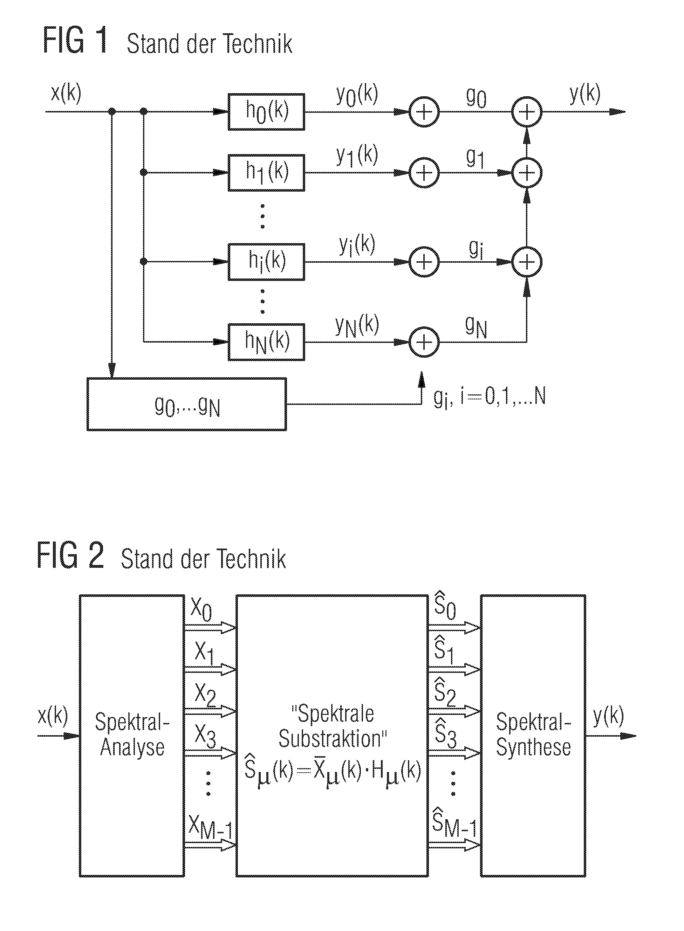

Um ein digitales Signal spektral zu modifizieren, ist es prinzipiell möglich, dieses Signal durch eine bestimmte Anzahl von Bandpässen zu leiten, wobei durch jeden Bandpass genau ein bestimmter Frequenzbereich durchgelassen wird und die übrigen Frequenzbereiche ausgefiltert werden. Dies ist als Beispiel in Figur 1 dargestellt. Ausgegangen wird in dieser Figur von einem zu modifizierenden Eingangssignal x(k), welches z. B. durch eine äquidistante Abtastung eines kontinuierlichen Zeitsignals, etwa einer Mikrofonspannung, in verschiedenen Zeitpunkten t = k·T entstanden sein kann, wobei T die sogenannte Abtastperiode des Signals ist. Das Signal x(k) ist somit eine Folge von Zahlen, die durch "k" nummeriert sind. Durch den in Figur 1 dargestellten Filter würde das Signal x(k) mit N+1 Bandpassfiltern, die jeweils die Impulsantwort $h_i(k)$ aufweisen, in N+1 Teilbandsignale $y_i(k)$, i=0,1,...,N zerlegt. Dies lässt sich durch folgende Gleichung mathematisch darstellen:

$$y_i(k) = \sum_{\kappa=0}^{k} x(k-\kappa) \cdot h_i(\kappa) \qquad (1)$$

Die gewünschte spektrale Modifikation des Eingangssignals x(k) wird dann erreicht, indem jedes Teilbandsignal mit einem individuellen Gewichtungskoeffizient bzw. "Verstärkungsmultiplikator" (Gain Multiplier) $g_i$, i=0,1,...,N, multipliziert wird. Das Ausgangssignal y(k) erhält man dann durch Überlagerung der gewichteten Teilbandsignale gemäß

$$y(k) = \sum_{i=0}^{N} g_i \cdot y_i(k) \qquad (2)$$

Neben einer Frequenzglättung - beispielsweise zum Ausgleich der Frequenzgänge bestimmter anderer Bauelemente innerhalb einer Signalübertragungskette oder zur Anpassung eines Signals an das menschliche Gehör - ist auch eine adaptive Rauschunterdrückung mit derartigen Filtern grundsätzlich möglich. Im ersten Fall können die Gewichtungsfaktoren $g_i$ konstant sein, bei einer adaptiven Rauschunterdrückung müssen diese Faktoren jedoch zeitlich variieren. Die Gewichtungsfaktoren $g_i$, für die in der Regel $0 \leq g_i \leq 1$ gilt, sorgen in jedem Fall für eine unterschiedliche Abschwächung der einzelnen Frequenzbänder. Für eine adaptive Rauschunterdrückung können die einzelnen Gewichtungsfaktoren $g_i$ jeweils separat auf Basis des zu modifizierenden Signals, beispielsweise im Spektralbereich, berechnet werden und vom aktuellen Signal-/Rausch-Verhältnis jedes einzelnen Teilbandsignals $y_i(k)$ abhängen.

Ein wesentliches Problem des in Figur 1 dargestellten "Referenzfilterbank"-Systems besteht darin, dass hierfür N+1 separate Bandfilter benötigt werden. Dies ist zum einen außerordentlich rechenaufwendig und zum anderen sehr teuer. Daher werden in realen Anwendungen zur spektralen Modifikation in der Regel sogenannte Analyse-Synthese-Systeme verwendet. Ein solches System ist in Figur 2 schematisch dargestellt. Das Eingangssignal x(k) wird dabei zunächst einer Spektralanalyse zugeführt, in der das Signal in geeignet gewählte Grundkomponenten zerlegt wird. Dies erfolgt mit Hilfe einer sogenannten Zeit-/Spektraltransformation, beispielsweise einer Fourier-Transformation bzw. einer Diskreten Fourier-Transformation (DFT), einer z-Transformation, einer Diskreten Cosinus-Transformation (DCT) o. Ä. Nach dieser Transformation des Eingangssignals x(k) vom Zeitbereich in den Spektralbereich findet dann eine sogenannte spektrale Subtraktion statt, wobei mathematisch gesehen die einzelnen spektralen Komponenten $X_\mu$(k), $\mu$=0,1,...M-1 jeweils mit bestimmten Faktoren, dem sogenannten Frequenzgang $H_\mu$(k), in dem betreffenden Frequenzbereich gewichtet werden. Die so erzeugten modifizierten spektralen Komponenten $S_\mu$(k) werden dann einer sogenannten Spektralsynthese zugeführt, in der die Signalanteile $S_\mu$(k) wieder einander passend überlagert werden, um das Ausgangssignal y(k) zu erzeugen. Diese Spektralsynthese erfolgt mit einer sogenannten Spektral-/Zeittransformation, d. h. einer inversen Zeit-/Spektraltransformation, beispielsweise mit einer Inversen Diskreten Fourier-Transformation (IDTF), einer Inversen Diskreten Cosinus-Transformation (IDCT) oder einer Inversen z-Transformation etc., mit der das Signal wieder in den Zeitbereich zurücktransformiert wird. Ein Problem bei diesen üblichen Signalverarbeitungsmethoden besteht darin, dass ein Analyse-Synthese-System in erster Linie für die Re-Synthese des Signals auszulegen ist. Insbesondere ist dabei darauf zu achten, dass Rückfaltungen (sogenanntes "Aliasing") durch Taktreduktion nach der Analyse sowie durch nicht-ideale Interpolationen im Zuge der Synthese vermieden werden. Andernfalls kann es zu unerwünschten Effekten wie beispielsweise Verzerrungen und Nachhall im störbefreiten Ausgangssignal kommen. Diese Anforderungen führen zu einem erhöhten Rechenaufwand und zu einer vergrößerten Verzögerung des gesamten Filtersystems.

Es ist daher eine Aufgabe der vorliegenden Erfindung, eine einfache und kostengünstige Alternative zu dem bekannten Stand der Technik zu schaffen, bei der insbesondere die Rückfaltungsprobleme und die Signalverzögerung durch das System reduziert werden.

Diese Aufgabe wird durch ein Verfahren gemäß Patentanspruch 1 und durch eine Filterbank gemäß Patentanspruch 10 gelöst.

Erfindungsgemäß wird bei diesem Verfahren das digitale Signal mit einem äquivalenten Zeitbereichsfilter mit einer effektiven Summenimpulsantwort gefiltert, indem - im Zeitbereich - das digitale Signal durch eine Verzögerungskette mit einer Anzahl von Verzögerungsstufen geleitet wird und an der Verzögerungskette, d.h. vor und/oder nach der Verzögerungskette und/oder zwischen den Verzögerungsstufen abgegriffene Signalanteile jeweils durch eine Filtereinheit mit einer gewichteten Tiefpass-Prototyp-Impulsantwort geleitet werden und die Signalanteile anschließend wieder aufsummiert werden. D.h. aus dem Eingangssignal werden durch die Verzögerungskette Signalblöcke einer bestimmten Länge gebildet, die dann von der Filtereinheit bearbeitet werden. Ein "äquivalenter Zeitbereichsfilter" ist dabei ein einzelnes Filter, dessen Frequenzgang mit dem Summenfrequenzgang einer Filterbank mit Gewichtung der Teilbandsignale übereinstimmt. Dementsprechend ist unter dem Begriff "effektive Summenimpulsantwort" eine Impulsantwort eines einzelnen Filters zu verstehen, die mit der Summe der gewichteten Impulsantworten der Bandpässe einer Filterbank übereinstimmt, und als "Tiefpass-Prototyp-Impulsantwort" wird eine Impulsantwort eines Tiefpasses verstanden, aus der die Impulsantworten einer Filterbank durch Modulation erzeugt werden.

Eine entsprechende Filterbank muss hierzu einen äquivalenten Zeitbereichsfilter zum Filtern des digitalen Signals mit einer effektiven Summenimpulsantwort aufweisen, welcher zum einen eine Verzögerungskette mit einer Anzahl von Verzögerungsstufen aufweist, um das zu modifizierende digitale Signal stufenweise zu verzögern und eine der Verzögerungskette nachgeschaltete Filtereinheit, welche an der Verzögerungskette abgegriffene Signalanteile jeweils mit einer gewichteten Tiefpass-Prototyp-Impulsantwort filtert, und eine Summiereinrichtung, um aus den gefilterten Signalanteilen ein Ausgangssignal zu erzeugen.

Ein entscheidender Vorteil des erfindungsgemäßen Verfahrens bzw. Aufbaus besteht folglich darin, dass es zur Filterung eines digitalen Eingangssignals in einer beliebigen gewünschten Weise letztlich ausreicht, nur ein Filter mit einer bestimmten Tiefpass-Prototyp-Impulsantwort aufzubauen. Es ist lediglich eine entsprechende Gewichtung dieser Tiefpass-Prototyp-Impulsantwort erforderlich. Die Gewichtung erfolgt hierbei vorzugsweise mit einer sogenannten Fensterfunktion, d. h. mit einer bestimmten Gewichtsfolge, welche zum Aufbau eines konstanten Filter konstant sein kann oder zum Aufbau eines adaptiven Filters variabel sein kann. Die Filterung erfolgt dabei unmittelbar im Zeitbereich. Das System zeichnet sich somit durch eine geringe Signalverzögerung aus.

Die abhängigen Ansprüche enthalten jeweils besonders vorteilhafte Ausführungsformen und Weiterbildungen der Erfindung, wobei insbesondere die erfindungsgemäße Filterbank auch entsprechend der Verfahrensansprüche weitergebildet sein kann und umgekehrt.

Um die Gewichtungsfaktoren zur Erreichung eines bestimmten Filterungsziels an das Signal bzw. ein Hintergrundsignal oder dgl. anzupassen, wird die Fensterfunktion vorzugsweise gemäß einer vorgegebenen Regel aus dem zu modifizierenden Signal bzw. dem externen Signal gewonnen. Im Gegensatz zur Filterung mit konstanten Gewichtungsfaktoren ist so auf einfache Weise eine adaptive Filterung möglich. Hierzu muss die erfindungsgemäße Filterbank zusätzlich mit einer entsprechenden Fensterfunktions-Berechnungseinrichtung ausgestattet sein, welche dann gemäß der vorgegebenen Regel aus dem zu modifizierenden Signal bzw. dem externen Signal die Fensterfunktion ermittelt.

Eine einfache Möglichkeit zur Realisierung dieses Verfahrens bzw. Aufbaus besteht dabei darin, das zu modifizierende Signal ähnlich wie bei der klassischen Analyse-Synthese-Methode zunächst eingangsseitig auszukoppeln und in den Spektralbereich zu transformieren und im Spektralbereich daraus die Gewichtungskoeffizienten zu berechnen. Unter Ermittlung der Fensterfunktion können dann die Gewichtungskoeffizienten vom Spektralbereich wieder in den Zeitbereich transformiert werden und dann im Zeitbereich zur Gewichtung der Tiefpass-Prototyp-Impulsantwort verwendet werden. Obwohl hier zur Berechnung der Koeffizienten ein ähnlicher Aufwand betrieben werden muss wie bei den üblichen Analyse-Synthese-Systemen, weist dennoch das gesamte Filtersystem eine erheblich geringere Verzögerung auf, weil die Filterung bzw. Faltung des Signals in der Regel nicht auf die Berechnung der Koeffizienten warten muss, da die Koeffizienten normalerweise ohnehin relativ langsam veränderlich sind. Darüber hinaus kann es nicht zur spektralen Rückfaltung kommen, da hier ja nur die Fensterfunktion, d. h. die Gewichtungskoeffizienten, zurücktransformiert werden und nicht das Signal selbst.

Eine entsprechende Fensterfunktions-Berechnungseinheit sollte zum einen eine Zeit-/Spektral-Transformationseinrichtung aufweisen, um das zu modifizierende Signal und/oder das externe Signal in den Spektralbereich zu transformieren. Darüber hinaus wird eine Gewichtungskoeffizienten-Berechnungseinrichtung benötigt, um auf Basis des transformierten, zu modifizierenden Signals und/oder externen Signals die Gewichtungskoeffizienten zu gewinnen. Schließlich ist eine Spektral-/Zeit-Transformationseinrichtung notwendig, um unter Ermittlung der Fensterfunktion die Gewichtungskoeffizienten vom Spektralbereich in den Zeitbereich zu transformieren.

Grundsätzlich können hierbei beliebige Zeit-/Spektral-Transformationen bzw. inverse Zeit-/Spektral-Transformationen genutzt werden, wie z. B. die z-Transformation, die sogenannte Hadamar-Transformation oder die Walsch-Transformation bzw. die Inversen davon. Es hat sich jedoch herausgestellt, dass die Diskrete Fourier-Transformation und dementsprechend die Inverse Diskrete Fourier-Transformation sowie die Diskrete Cosinus-Transformation bzw. die Inverse Diskrete Cosinus-Transformation besonders geeignet sind, da sie die besten Transformationseigenschaften aufweisen. Durch die Transformationseigenschaften sind aber letztlich auch die Filtereigenschaften des Gesamtsystems bestimmt, so dass mit diesen Transformationsmethoden die besten Filtereigenschaften zu erreichen sind.

Sofern eine Diskrete Fourier-Transformation verwendet wird, bietet es sich an, aus Geschwindigkeitsgründen möglichst die sogenannte "Fast-Fourier-Transformation" (FFT; Schnelle Fourier-Transformation) zu verwenden. Um das beste Ergebnis zu erzielen, sollte die Hin- und Rücktransformation zur Berechnung der Gewichtungsfunktionen jeweils mit der gleichen Transformationsart erfolgen.

Vorzugsweise wird bei der Ermittlung der Fensterfunktion ein mittels einer Verzögerungskette gebildeter aktuell im Filter bearbeiteter Signalblock des Eingangssignals berücksichtigt. So können die Gewichtungsfaktoren vorteilhafterweise unter Verwendung der gewichteten Zustandsvariablen des Zeitbereichsfilters berechnet werden. Die Zustandsvariablen sind hierbei die aktuell in der Verzögerungskette des Zeitbereichsfilters anstehenden Abtastwerte des Eingangssignals. Hierzu weist die Fensterfunktions-Berechnungseinrichtung besonders bevorzugt eine der Verzögerungskette des äquivalenten Zeitbereichsfilters entsprechende Verzögerungskette für das Eingangssignal auf. Alternativ oder zusätzlich können auch eine Anzahl vorhergehender im Filter bearbeiteter Signalblöcke berücksichtigt werden, d.h. es werden beispielsweise zusätzlich oder ausschließlich die gewichteten Zustandsvariablen des Zeitbereichsfilters eines oder mehrerer vorhergehender Signalblöcke des Eingangssignals berechnet.

Die Verzögerungsstufen innerhalb der Verzögerungskette können zum einen vorzugsweise so aufgebaut sein, dass sie jeweils das Signal um genau eine Abtastperiode des zu modifizierenden Signals verzögern. Dadurch wird das Signal jeweils um genau einen Abtastwert verschoben. Hierdurch wird eine gleichförmige Frequenzauflösung des Filters erreicht. Andererseits ist es auch möglich, die Filterbank so aufzubauen, dass eine ungleichmäßige Spektralauflösung vorliegt. Dies bietet die Möglichkeit, das Signal innerhalb des Filtersystems bezüglich der Frequenzauflösung beispielsweise an das menschliche Gehör anzupassen.

Eine solche Frequenzverzerrung der Filterbank lässt sich besonders einfach erreichen, wenn die Verzögerungsstufen so ausgewählt werden, dass zumindest ein Teil der Verzögerungsstufen eine sogenannte Allpass-Transfer-Funktion aufweisen. Solche sogenannten "Allpass-Filter erster Ordnung" lassen zwar alle Frequenzen gleichmäßig durch, jedoch wird die Phase frequenzabhängig verändert. Mit einem simplen Austausch der konstanten Verzögerungsstufen durch Verzögerungsstufen mit Allpass-Transfer-Funktion lässt sich z.B. beliebig genau die ungleichförmige Frequenzauflösung des Gehörs erzielen.

Das erfindungsgemäße Verfahren bzw. die erfindungsgemäße Filterbank kann prinzipiell in beliebigen digitalen Signalverarbeitungseinrichtungen zur Bearbeitung beliebiger digitaler Signale verwendet werden. Ein Haupteinsatzgebiet liegt jedoch im Bereich der Sprach- und sonstigen Audiosignale. Ganz besonders eignet sich der Einsatz des erfindungsgemäßen Verfahrens und der erfindungsgemäßen Filterbank im Bereich von Empfängern bzw. Sendern in Mobilfunknetzen, d. h. sowohl innerhalb von Mobilfunkgeräten als auch innerhalb von Netzkomponenten des Mobilfunknetzes, wie z.B. Mobilfunk-Basisstationen oder Mobilfunk-Vermittlungseinrichtungen.

Die Erfindung wird im Folgenden unter Hinweis auf die beigefügten Figuren anhand von Ausführungsbeispielen noch einmal näher erläutert. Es zeigen:

Figur 1 eine schematische Darstellung einer klassischen Referenzfilterbank mit N+1 verschiedenen Bandpassfiltern,

Figur 2 eine schematische Darstellung eines herkömmlichen Analyse-Synthese-Systems zur Geräuschreduktion,

Figur 3 eine schematische Darstellung einer erfindungsgemäßen Filterbank mit einem äquivalenten Zeitbereichsfilter und einer Fensterfunktions-Berechnungseinrichtung,

Figur 4 eine schematische Darstellung der Übertragungsfunktionen einer Cosinus-modulierten Referenzfilterbank gemäß Figur 1,

Figur 5 eine schematische Darstellung eines ersten Ausführungsbeispiels eines äquivalenten Zeitbereichsfilters einer erfindungsgemäßen Filterbank gemäß Figur 3,

Figur 6 eine schematische Darstellung eines zweiten Ausführungsbeispiels eines äquivalenten Zeitbereichsfilters einer erfindungsgemäßen Filterbank gemäß Figur 3,

Figur 7 eine Darstellung einer nicht gleichförmigen Frequenzverzerrung mit Hilfe einer Allpass-Transformation,

Figur 8 eine Darstellung der Wirkung der Frequenzverzerrung mittels der Allpass-Transformation nach Figur 7 auf die Frequenzgänge unterschiedlicher Bandpassfilter,

Figur 9 eine Abbildung der Bark-Skala auf die Frequenzskala zur Darstellung der gehörrichtigen Frequenzauflösung nach der Schallauflösung,

Figur 10 ein erstes Ausführungsbeispiel für eine Fensterfunktions-Berechnungseinrichtung für eine erfindungsgemäße Filterbank gemäß Figur 3,

Figur 11 eine schematische Darstellung für den ersten Teil eines zweiten Ausführungsbeispiels für eine Fensterfunktions-Berechnungseinrichtung für eine erfindungsgemäße Filterbank gemäß Figur 3.

Anhand eines Vergleichs zwischen den schematischen Darstellungen der unterschiedlichen Filterbankkonzepte in den Figuren 1 bis 3 wird sehr gut der Unterschied der erfindungsgemäßen Filterbank 1 bzw. des erfindungsgemäßen Verfahrens gegenüber den üblicherweise verwendeten Analyse-Synthese-Systemen (Figur 2) und einer aus N+1 einzelnen Bandpass-Filtern aufgebauten Referenzfilterbank (Figur 1) deutlich. Die Funktionsweisen dieser Referenzfilterbank gemäß Figur 1 und der Analyse-Synthese-Methode, bei der zunächst das gesamte Signal einer Spektralanalyse unterzogen wird, dann im Spektralbereich eine Spektralsubtraktion durchgeführt wird und anschließend die Signalanteile wieder synthetisiert werden, wurden bereits eingangs genauer beschrieben.

Im Gegensatz dazu wird bei dem erfindungsgemäßen Verfahren das Eingangssignal x(k) im Zeitbereich, d. h. ohne zuvorige Spektralanalyse, einem äquivalenten Zeitbereichsfilter 2 zugeführt und dort mit einer Summenimpulsantwort gefaltet bzw. gefiltert. Diese Summenimpulsantwort entsteht aus der Faltung einer Tiefpass-Prototyp-Impulsantwort h(k) mit einer Gewichtsfolge, d. h. Fensterfunktion w(k). Daraus ergibt sich unmittelbar das gewünschte Ausgangssignal y(k).

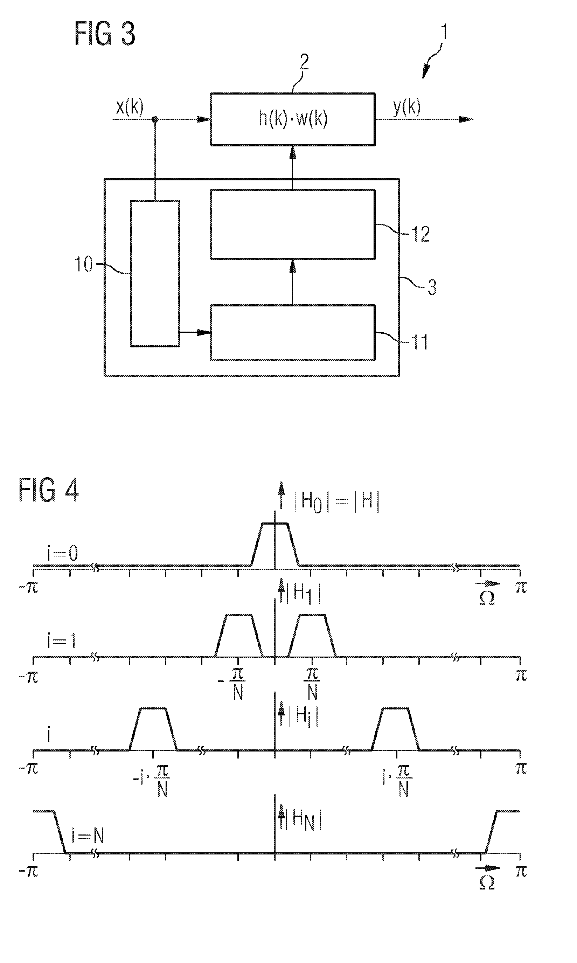

Bei dem in Figur 3 dargestellten Ausführungsbeispiel handelt es sich um ein Filter 2 zur adaptiven Modifizierung des Eingangssignals x(k) in Abhängigkeit vom jeweiligen zu modifizierenden Eingangssignal x(k), beispielsweise zur Rauschunterdrückung. Daher wird hier die Fensterfunktion w(k) aus dem Eingangssignal x(k) selbst gewonnen. Dies erfolgt in einer Fensterfunktions-Berechnungseinrichtung 3, welche hierzu eine Zeit-/Spektral-Transformationseinrichtung 10 aufweist, um das Eingangssignal x(k) in den Spektralbereich zu transformieren. In einer Gewichtungskoeffizienten-Berechnungseinrichtung 11 werden dann im Spektralbereich aus dem transformierten Eingangssignal Gewichtungskoeffizienten $g_0,...,g_N$ berechnet. Diese Gewichtungskoeffizienten $g_0,...,g_N$ werden schließlich in einer Spektral-/Zeit-Transformationseinrichtung 12, beispielsweise hier mittels einer Diskreten Fourier-Transformation (DFT), in den Zeitbereich zurücktransformiert. Das Ergebnis ist die gewünschte Fensterfunktion w(k). Diese kann dann im äquivalenten Zeitbereichsfilter 2 mit der Tiefpass-Prototyp-Impulsantwort h(k) und dem Eingangssignal gefaltet werden.

Alternativ könnte auch eine adaptive Berechnung der Fensterfunktion w(k) unter Nutzung eines anderen externen Signals, beispielsweise eines separat gemessenen Hintergrundgeräusch-Signals oder Ähnlichem, ermittelt werden.

Sofern eine feste Filtercharakteristik gewünscht wird, kann die Fensterfunktion w(k) auch - nach entsprechender Berechnung - fest im Filter implementiert werden, beispielsweise um eine Signalanpassung an das menschliche Gehör zu erreichen oder um ungünstige Frequenzgänge anderer in der Signalleitung vorhandener Komponenten wieder auszugleichen.

Im Folgenden wird anhand eines konkreten Beispiels erläutert, dass die mit dem in Figur 3 schematisch dargestellten Verfahren bzw. System erreichte Filterung genau der Filterung entspricht, die man auch mit der sehr aufwendig mit N+1 unterschiedlichen Bandpässen im Zeitbereich aufgebauten Referenzfilterbank gemäß Figur 1 erreicht. Zum Ausgangspunkt der Überlegungen wird dabei angenommen, dass die einzelnen Bandpassfilter der Referenzfilterbank nach Figur 1 jeweils von einem FIR-Prototyp Tiefpassfilter der Länge n mit einer Impulsantwort h(k) mit k=0,1...,n-1 mittels einer Cosinus-Modulation abgeleitet sind. (FIR = Finite Impuls Response; begrenzte Impulsantwort; dies bedeutet, dass es sich um einen nicht rekursiven Filter handelt). Es gilt dann

$$h_i(k) = \begin{cases} h(k) & ; \quad i = 0 \\ 2 \cdot h(k) \cdot \cos\left(\dfrac{\pi}{N} i(k - k_0)\right) & ; \quad 1 \le i \le N-1 \\ (-1)^{(k-k_0)} \cdot h(k) & ; \quad i = N \end{cases} \qquad (3a)$$

für k=0,1, ... n-1. Hierbei ist $k_0$ ein konstanter Verzögerungswert bzw. Phasenparameter.

Durch eine übliche Fourier-Transformation erhält man die entsprechenden Frequenzgänge (Übertragungsfunktionen) dieser Impulsantworten wie folgt:

$$H_i(e^{j\Omega}) = \begin{cases} H(e^{j\Omega}) & ; \quad i = 0 \\ H\left(e^{j\left(\Omega - \frac{\pi}{N}i\right)}\right) \cdot e^{-j\frac{\pi}{N}ik_0} + H\left(e^{j\left(\Omega + \frac{\pi}{N}i\right)}\right) \cdot e^{+j\frac{\pi}{N}ik_0} & ; \quad 1 \le i \le N-1 \\ H(e^{j(\Omega-\pi)}) \cdot e^{-j\pi k_0} & ; \quad i = N \end{cases} \qquad (3b)$$

Figur 4 zeigt eine schematische Darstellung dieser Frequenzgänge. Aufgetragen ist jeweils der Betrag des Frequenzgangs $|H_i|$, i=0,1,...,N, über der auf π normierten Frequenz Ω.

Es wird weiterhin davon ausgegangen, dass die Gewichtungsfaktoren $g_i$ zumindest für eine kurze begrenzte Zeitperiode konstant sind. Diese Annahme ist zulässig, da auch in der Praxis bei einer adaptiven Filterung die Koeffizienten, welche ja mit den auszufilternden Störungen korrespondieren, ohnehin in der Regel relativ zum eigentlichen Signal nur sehr langsam veränderlich sind.

In diesem Fall kann das in Figur 1 dargestellte Referenzfilterbank-System als lineares System betrachtet werden. Daher kann dieses System auch durch eine Gesamtimpulsantwort $h_s(k)$ beschrieben werden, welche der Summe der individuell skalierten Impulsantworten $h_i(k)$ entspricht, d. h.:

$$\begin{aligned} h_s(k) &= \sum_{i=0}^{N} g_i \cdot h_i(k) \\ &= g_0 \cdot h(k) + 2 \sum_{i=1}^{N-1} g_i \cdot h(k) \cdot \cos\left(\frac{\pi}{N} i(k-k_0)\right) + g_N \cdot h(k) \cdot (-1)^{k-k_0} \\ &= h(k) \cdot \left[ g_0 + 2 \sum_{i=1}^{N-1} g_i \cdot \cos\left(\frac{\pi}{N} i(k-k_0)\right) + g_N \cdot (-1)^{(k-k_0)} \right] \\ &= h(k) \cdot w(k) \end{aligned} \qquad (4)$$

Wie die letzten beiden Zeilen in Gleichung (4) zeigen, lässt sich die komplette Referenzfilterbank entsprechend der vorliegenden Erfindung durch ein einzelnes äquivalentes Zeitbereichsfilter ersetzen. Die effektive Gesamtimpulsantwort $h_s(k)$ ist dabei das Produkt der Prototyp-Tiefpass-Impulsantwort h(k) mit einer Gewichtsfunktion w(k).

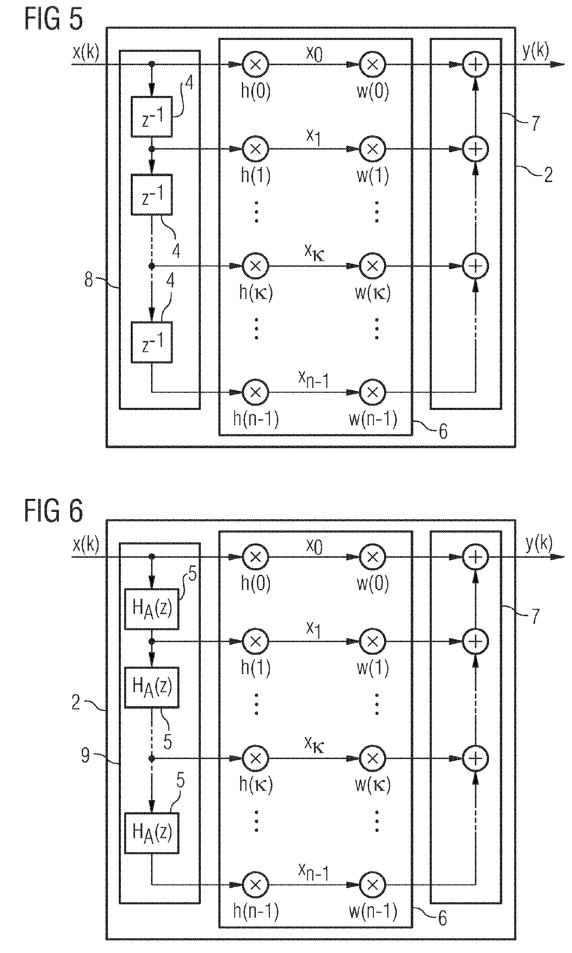

Eine Möglichkeit, ein entsprechendes äquivalentes Zeitbereichsfilter 2 in sehr einfacher Weise technisch zu implementieren, ist in Figur 5 dargestellt. Hierbei wird das Eingangssignal x(k) im Zeitbereich in einer Verzögerungskette 8 mit einer Anzahl von n-1 Verzögerungsstufen 4 zugeleitet. In dieser Verzögerungskette 8 erfolgt bei dem in Figur 5 dargestellten Ausführungsbeispiel bei jeder der Verzögerungsstufen 4 eine Verzögerung um den Verzögerungsoperator $z^{-1}$. Hierbei handelt es sich um den Verzögerungsoperator der z-Transformation, der eine Signalverschiebung um das Abtastintervall T symbolisieren soll. Das heißt, das eingehende Signal x(k) wird jeweils um einen Abtastwert verschoben. Durch die Verzögerung des Signals x(k) in der Verzögerungskette 8 wird folglich ein Signalblock (auch "Rahmen" oder "Sample" genannt) kurzzeitig gespeichert. Solche Verzögerungsketten 8 werden daher oft auch "Speicherketten" genannt. Die Länge des Signalblocks ist um 1 höher als die Anzahl der n-1 Verzögerungsstufen 4. Bei dem dargestellten Beispiel werden jeweils Signalblöcke des Eingangssignals x(k) mit der Länge n gebildet. Ein Signalblock wird dann im Weiteren in einer (Block-) Filtereinheit 6 zunächst mit der Tiefpass-Prototyp-Impulsantwort h(k) gefiltert, wobei durch die Speicherkette mit den Verzögerungsstufen 4 jeder Signalwert x(k), k=0,...,n-1 mit dem entsprechenden Wert der Tiefpass-Prototyp-Impulsantwort h(k) multipliziert wird. Dadurch entstehen insgesamt n verschiedene Signalwerte $x_0$, $x_1$, ... $x_k$, ... , $x_{n-1}$, die in einem weiteren Schritt im Filter 6 mit den einzelnen Funktionswerten w (k), =0, ... , κ, ..., n-1 multipliziert, d. h. gewichtet werden. Anschließend erfolgt eine Überlagerung der Signalanteile in einer Summiereinrichtung 7, wodurch sich das gewünschte Ausgangssignal y(k) ergibt.

Anhand des eingangs verwendeten Beispiels kann weiter gezeigt werden, dass sich mittels einer Diskreten Fourier-Transformation, insbesondere einer Fast-Fourier-Transformation problemlos eine Fensterfunktion w(k) so ermitteln lässt, dass bei geeigneter Wahl der Tiefpass-Prototyp-Impulsantwort h(k) auch eine perfekte Rekonstruktion des Signals x(k) im Zeitbereichsfilter 2 erreicht werden kann. D. h. dass bei einer Wahl von Gewichtungskoeffizienten $g_i$ = 1 für i=0,1,...,n-1 das Gesamtsystem als Ausgangssignal - abgesehen von einer konstanten Verzögerung - wieder das Eingangssignal x(k) ausgibt.

Aufgrund des Verhaltens der Cosinus-Funktion ist die Fensterfunktion w(k) immer symmetrisch (siehe Gleichung (4)). D. h. die Fensterfunktion w(k) ist entsprechend folgender Definition zeitlich nicht beschränkt:

$$w(k+\lambda \cdot 2N)=w(k) \; ; \; \lambda = \text{konstante} \in \{1,2,3,...\} \tag{5}$$

Lediglich für die nachfolgenden Überlegungen wird weiterhin die Anzahl N+1 der Gewichtungskoeffizienten $g_i$ in der Referenzfilterbank gemäß Figur 1 künstlich auf eine Zahl M=2N entsprechend der Regel

$$g_{2N-i} \stackrel{!}{=} g_i \; ; \; i = 0,1,\cdots,2N-1 \tag{6}$$

ausgedehnt. Die Fensterfunktion w(k) kann dann mathematisch wie folgt dargestellt werden:

$$\begin{aligned}
w(k) &= \sum_{i=0}^{2N-1} g_i \cdot \cos\left(\frac{2\pi}{2N}i(k-k_0)\right) \\
&= \text{Re}\left\{\sum_{i=0}^{2N-1} g_i e^{-j\frac{2\pi}{2N}i(k-k_0)}\right\} \\
&= \text{DFT}\left\{g_i \cdot e^{j\frac{\pi}{N}ik_0}\right\}
\end{aligned} \tag{7}$$

Dies beweist, dass die Fensterfunktion w(k) mittels einer Diskreten Fourier-Transformation bzw. einer Fast-Fourier-Transformation der Länge M=2N berechnet werden kann:

$$w(k) = DFT\left\{g_i \cdot e^{j\frac{\pi}{N}ik_0}\right\} \tag{8}$$

Wie Gleichung (6) zeigt, sind die Gewichtungsfaktoren $g_i$ reell-wertig und symmetrisch. Daher ist auch das Ergebnis der Transformation, d. h. die Fensterfunktion w(k), reellwertig, da der Imaginärteil der Diskreten Fourier-Transformation der Gewichtungsfaktoren $g_i$ Null ist. Dies zeigt, dass anstelle einer Diskreten Fourier-Transformation ebenso auch die äquivalente Diskrete Cosinus-Transformation genutzt werden kann.

Der Phasenkorrekturterm in Gleichung (8) ist abhängig von dem ganzzahligen Verzögerungswert $k_0$. Wie bereits erwähnt, wird gefordert, dass in dem Fall $g_i$=1, i=0,1,2,...,2N-1 das System eine perfekte Rekonstruktion des Eingangssignals x(k), abgesehen von einer konstanten Verzögerung $k_0$, erzeugt. Das heißt, es soll gelten:

$$y(k) = x(k - k_0) \tag{9}$$

Dies kann erreicht werden, indem eine Tiefpass-Prototyp-Impulsantwort mit einer Länge n verwendet wird, für die

$$n = L \cdot 2N; L \in \{1,2,...\} \tag{10a}$$

gilt. D. h. die Tiefpass-Prototyp-Impulsantwort soll eine Länge n aufweisen, die der doppelten Anzahl N der Bandpassfilter einer zum Zeitbereichsfilter äquivalenten Referenzfilterbank oder einem ganzen Vielfachen davon entspricht.

Außerdem muss der Phasenparameter $k_0$ die Bedingung

$$k_0 = \lambda \cdot N \; ; \; \lambda = \text{konstant} \in \{1,2,3,...\} \tag{10b}$$

erfüllen. Für diesen Fall kann der Phasenkorrekturterm in Gleichung (8) sehr vereinfacht geschrieben werden:

$$e^{j\frac{\pi}{N}ik_0} = e^{j\pi i\lambda} = (-1)^{i\lambda} = \begin{cases} (-1)^i & ; \quad \lambda = \text{ungerade} \\ \\ 1 & ; \quad \lambda = \text{gerade} \end{cases} \tag{10c}$$

In diesem Fall erhält man für die Fensterfunktion w(k):

$$w(k) = \sum_{i=0}^{2N-1} (-1)^{i\lambda} \cdot e^{-j\frac{2\pi}{2N}ik} = \begin{cases} 1 ; & k = m \cdot 2N & ; \lambda = \text{gerade} \\ 0 ; & \text{sonst} & m = 0, \pm 1, \pm 2, ... \\ 1 ; & k = (2m-1) \cdot N & ; \lambda = \text{ungerade} \end{cases} \tag{11}$$

Um nun eine perfekte Rekonstruktion des Eingangssignals erreichen zu können, muss die Tiefpass-Prototyp-Impulsantwort h(k) die folgenden Bedingungen erfüllen:

$$h(k) = \begin{cases} 1 & ; \quad k = k_0 = \lambda \cdot N \\ 0 & ; \quad k = k_0 \pm 2mN, m \in \{1,2,3,...\} \\ \text{beliebig} & ; \quad \text{sonst} \end{cases} \qquad (12)$$

Das heißt, dass die Tiefpass-Prototyp-Impulsantwort $h(k)$ zu einem bestimmten ersten Zeitpunkt, welcher dem konstanten Verzögerungswert $k_0$ der Tiefpass-Prototyp-Impulsantwort entspricht, den Funktionswert "1" aufweisen muss. Zu bestimmten weiteren äquidistanten Zeitpunkten, welche zu dem besagten ersten Wert um einen Wert beabstandet sind, der der Länge $M=2N$ der Prototyp-Tiefpass-Impulsantwort entspricht, muss die Impulsantwort $h(k)$ den Funktionswert "0" aufweisen. Die übrigen Funktionswerte der Tiefpass-Prototyp-Impulsantwort $h(k)$ können dann beliebig gewählt werden, um die spektralen Auflösungserfordernisse zu erfüllen.

Es ist zu beachten, dass die Gesamtverzögerung des perfekt rekonstruierenden Systems dem Wert $k_0$ entspricht, auch dann, wenn $h(k)$ ein Filter mit nicht-linearer Phase ist. Im Falle einer Prototyp-Impulsantwort $h(k)$ mit linearer Phase, d. h. mit $n=L \cdot 2N$ und $k_0=L \cdot N$, hat die Gesamtverzögerung entsprechend Gleichung (6) für beliebige reellwertige Gewichtungskoeffizienten $g_i$ ebenfalls den Wert $k_0$.

Bei der in Figur 5 dargestellten Realisation des äquivalenten Zeitbereichsfilters 2 werden jeweils konstante Verzögerungselemente 4 eingesetzt, die das Signal um genau eine Abtastperiode T verzögern. In diesem Fall weist das äquivalente Zeitbereichsfilter 2 eine gleichförmige Frequenzauflösung auf. Bei einigen Anwendungen ist es aber vorteilhaft, ein äquivalentes Zeitbereichsfilter 2 mit einer nicht gleichförmigen Frequenzauflösung zu verwenden. So ist es beispielsweise durch eine ungleichmäßige Spektralauflösung möglich, das Signal an das menschliche Gehör anzupassen, indem z. B. bei tiefen Frequenzen schmale Filter verwendet werden und bei hohen Frequenzen breitere Filter.

Eine allgemein bekannte Technik, um eine ungleichförmige Frequenzverzerrung in digitalen Filtern zu erreichen, besteht darin, die Verzögerungselemente durch Allpassfilter erster Ordnung zu ersetzen, d. h. durch Verzögerungselemente, die eine sogenannte Allpass-Transfer-Funktion aufweisen (z.B. A.G. Constantinides: Frequency Transformations for Digital Filters. Electronic Letters, 3(11), 487-489, 1967; W. Schüßler, W. Winkelnkemper: Variable Digital Filters. AEÜ, 24, 524-525, 1970). Diese Methode wird beispielsweise dafür genutzt, um variable digitale Filter zu entwickeln und zu implementieren. So kann auf diese Weise ein bestimmter Tiefpass mit einer bestimmten Grenzfrequenz $\Omega_c$ von einem Prototyp-Tiefpass-Filter mit einer Grenzfrequenz $\Omega_0$ generiert werden. Ein weiterer Anwendungsfall dieser Verzerrungstechnik besteht darin, sogenannte Kurzzeitspektralanalysen mit nicht uniformer Spektralauflösung mittels Diskreter Fourier-Transformation bzw. mit Hilfe diskreter Filterbänke aufzubauen.

Im vorliegenden Fall wird diese Transformationstechnik dazu genutzt, um innerhalb des äquivalenten Zeitbereichsfilters 2 eine ungleichmäßige Frequenzauflösung zu erzielen. Dies ist in Figur 6 dargestellt. Der Aufbau gemäß Figur 6 unterscheidet sich von dem Aufbau gemäß Figur 5 lediglich dadurch, dass anstelle der Verzögerungsstufen 4 mit gleichmäßiger Frequenzauflösung nun Verzögerungsstufen 5 mit einer Allpass-Transfer-Funktion verwendet werden.

Der Effekt dieser Maßnahme wird besonders gut verdeutlicht, wenn man die durch die z-Transformation entstandenen Übertragungsfunktionen der Original-Bandpass-Impulsantworten der Referenzfilterbank gemäß Figur 1 betrachtet:

$$H_i(z) = \sum_{k=0}^{n-1} h_i(\kappa) \cdot z^{-\kappa} \qquad (13a)$$

Werden in Gleichung (13a) die Verzögerungselemente $z^{-k}$ durch Allpass-Transfer-Funktionen $H_A(z)$ ersetzt, so erhält man die Übertragungsfunktionen:

$$\widetilde{H}_i(z) = \sum_{\kappa=0}^{n-1} h_i(\kappa) \cdot H_A^\kappa(z) \qquad (13b)$$

Dabei ist beispielsweise

$$H_A(z) = \frac{z^{-1} - a}{1 - a \cdot z^{-1}} \; ; -1 \le a \le +1 \tag{14a}$$

Aus Gleichung (14a) ist zu ersehen, dass bei Einsetzen der Variablen a=0 die Allpass-Transfer-Funktion $H_A$(z) den Wert $z^{-1}$ annimmt, d. h. der Aufbau gemäß Figur 6 stimmt dann mit dem Aufbau gemäß Figur 5 überein.

Da der Betrag der Frequenzantwort aller Allpass-Verzögerungselemente gemäß der Gleichung

$$H_A(e^{j\Omega}) = 1 \cdot e^{-j\varphi_A(\Omega)} \tag{14b}$$

konstant ist, wird durch die Verwendung der Allpass-Elemente die Frequenzachse entsprechend der Phasencharakteristik der Allpass-Elemente gemäß der Gleichung

$$\Omega^t = \varphi_A(\Omega) = 2 \cdot \arctan\left[\frac{1+a}{1-a}\tan\left(\frac{\Omega}{2}\right)\right] \tag{14c}$$

verzerrt.

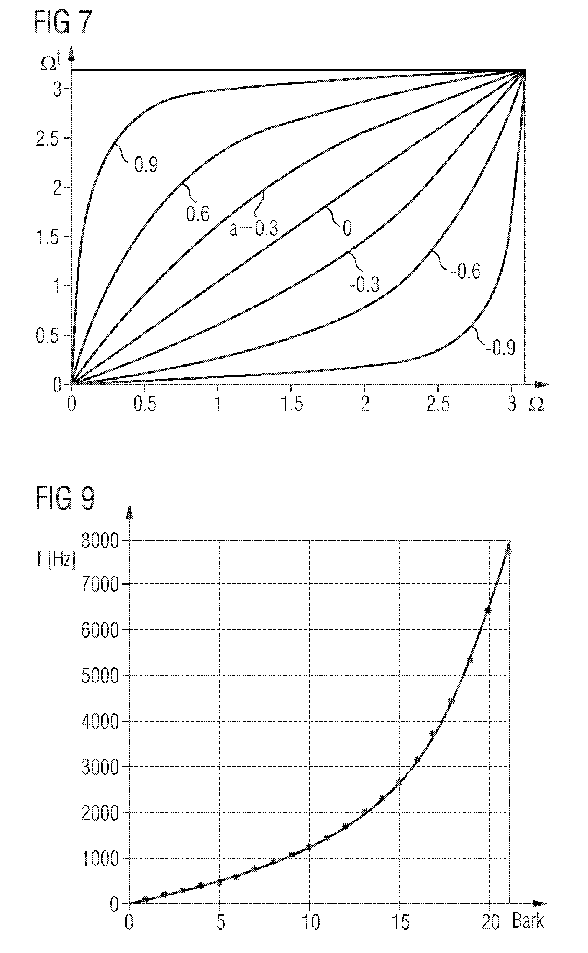

Diese Frequenzverzerrungs-Charakteristik wird in Figur 7 für einige Werte der Variablen a dargestellt. Aufgetragen ist darin die transformierte normierte Frequenz $\Omega^t$ über der normierten ursprünglichen Frequenz $\Omega$. Die Normierung erfolgte hierbei jeweils so, dass die halbe Abtastfrequenz, beispielsweise bei einem GSM-Mobilfunkgerät 4 kHz, dem Wert $\pi$ entspricht.

Wird diese Frequenzverzerrung auf eine Referenzfilterbank angewandt, wie sie in Figur 1 dargestellt ist, so wird jeder der separaten Bandpassfilter der Referenzfilterbank individuell entsprechend der Gleichung

$$\widetilde{H}_i\left(e^{j\Omega}\right) = \sum_{\kappa=0}^{n-1} h_i(\kappa) \cdot \left[e^{-j\varphi_A(\Omega)}\right]^\kappa$$
$$= H_i\left(e^{j\Omega^t}\right) \tag{15}$$

transformiert.

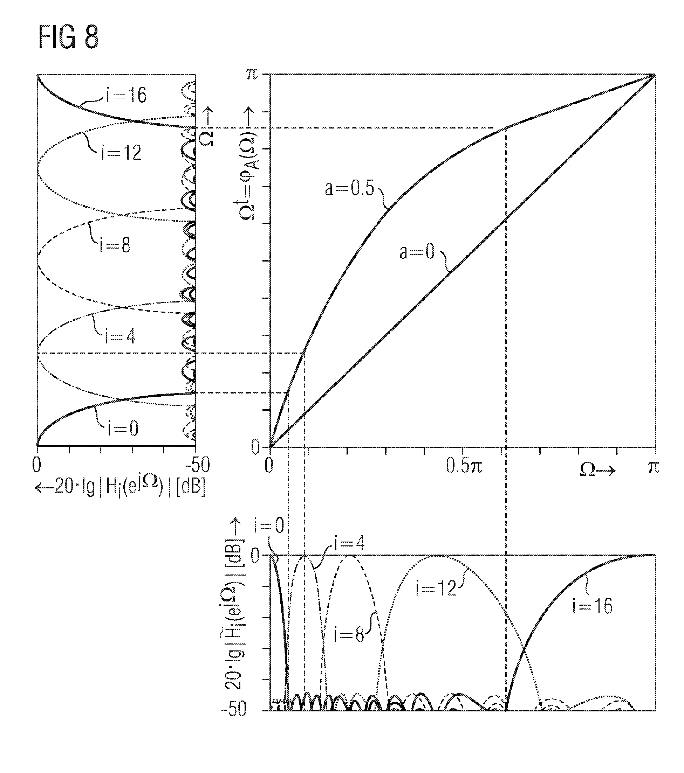

Ein Beispiel hierfür ist in Figur 8 aufgezeigt. Die mittlere Graphik zeigt hierbei eine Darstellung analog zu Figur 7, d. h. es ist hierin die transformierte normierte Frequenz $\Omega^t$ über der ursprünglichen Frequenz $\Omega$ aufgetragen. Als Beispiele sind hier zum einen der Spezialfall a=0, bei dem die Allpass-Elemente in die reinen Verzögerungselemente $z^{-1}$ übergehen, und zum anderen die Variable a=0,5 gewählt.

Links neben dieser Graphik sind die Original-Frequenzgänge verschiedener Bandpassfilter der Referenzfilterbank, hier für den ersten Tiefpass mit der Impulsantwort $h_0$, für die Bandpässe mit den Impulsantworten $h_4$, $h_8$, $h_{12}$ sowie für den Hochpass mit der Impulsantwort $h_{16}$ dargestellt. Dabei ist hochkant, d. h. um 90° gedreht, jeweils die Dämpfung über der normierten Frequenz $\Omega$ aufgetragen.

Unter der mittleren Graphik sind die aufgrund der ungleichmäßigen Frequenzauflösung transformierten Frequenzgänge dieser Bandpässe dargestellt, wobei auch hier wieder die Dämpfung über der normierten ursprünglichen Frequenz $\Omega$ aufgetragen ist. In dem Spezialfall a=0 würden die Originalfrequenzgänge unverändert bleiben. Für den weiteren dargestellten Fall a=0,5 ergibt sich die in dem unteren Diagramm gezeigte Frequenzgangsverteilung, bei der die Frequenzgänge des Tiefpasses und der niedrigeren Bandpässe, d. h. der Bandpässe mit niedrigerer Mittenfrequenz, schmalbandiger geworden sind und die Frequenzgänge der Hochpässe bzw. Bandpässe mit höherer Mittenfrequenz breitbandiger.

Der gleiche Effekt wird erzielt, wenn in dem äquivalenten Zeitbereichsfilter gemäß Figur 8 die Allpass-Transfer-Elemente $H_A$(z) als Verzögerungsstufen 5 verwendet werden. Dies liegt daran, dass die Gesamtfrequenzantwort der Struktur gemäß Figur 6 exakt der Bandpassfrequenzantwort des Referenzsystems gemäß Figur 1 entspricht, weil jeder der Bandpassfilter gemäß Figur 1 entsprechend Gleichung 13 b transformiert ist. Es sollte hierbei beachtet werden, dass die ursprünglich zeitlich begrenzte Impulsantwort des Systems in eine rekursive Impulsantwort konvertiert wird.

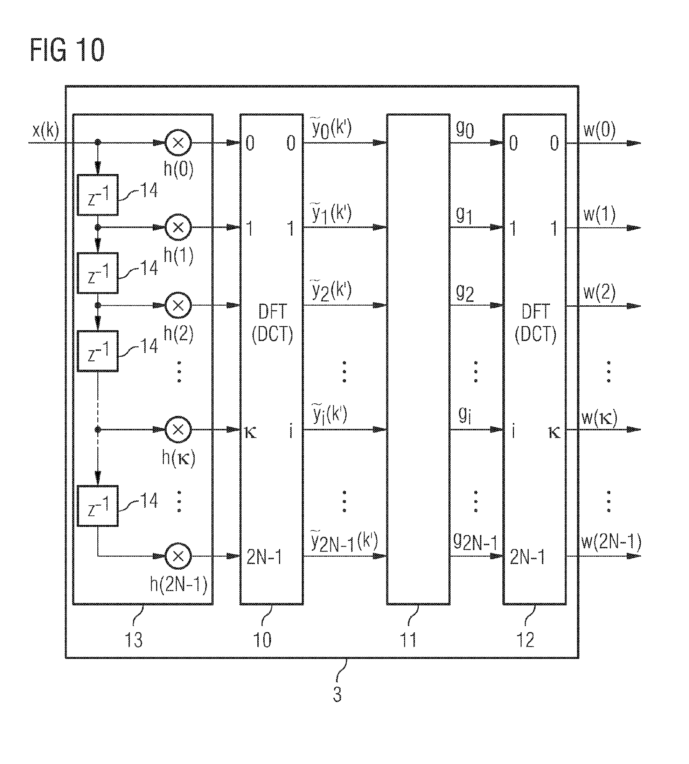

Figur 9 zeigt, wie mit Hilfe dieser Technik in einem erfindungsgemäßen Filtersystem eine sehr gute Anpassung der Frequenzcharakteristik des Eingangssignals an das menschliche Gehör erreicht wird. In dieser Graphik ist die Bark-Skala auf die Frequenzskala abgebildet. Dargestellt ist die gehörrichtige Frequenzauflösung nach der der Schallauflösung in Form der Mittenfrequenzen der Bark-Frequenzbereiche (Sternchen) im Bereich 0 bis 8 kHz. Die durchgezogene Linie zeigt als Vergleich die (theoretische) Transformationskurve eines erfindungsgemäßen Filters mit den Parametern N+1=21 (*M*=40) und unter Verwendung von Verzögerungsstufen mit Allpass-Transfer-Funktionen mit a=0,565.

Wie bereits erwähnt, können die Gewichtungsfaktoren, d. h. die Funktionswerte der Fensterfunktion $w(k)$, grundsätzlich konstant sein, um eine feste Filtercharakteristik zu erzielen. Um ein adaptives Filter aufzubauen, um beispielsweise ein verrauschtes Signal zu verbessern oder eine beliebige andere adaptive spektralbereichbasierende Filterung zu erreichen, muss diese Fensterfunktion $w(k)$ jedoch variabel sein. Als repräsentatives Beispiel wird im Folgenden - ohne Beschränkung der Erfindung - die adaptive Filterung zum Zwecke einer Rauschunterdrückung beschrieben.

Wie eingangs beschrieben, beruht die konventionelle spektrale Subtraktion zur Rauschunterdrückung auf einer Kurzzeit-Spektralanalyse und anschließender Synthese unter Nutzung der Diskreten Fourier-Transformation. Die für die hierfür genutzte Diskrete Fourier-Transformation bzw. Inverse Diskrete Fourier-Transformation benötigten Parameter, wie z. B. die Transformations- bzw. Blocklänge M, die Fensterfunktion und die Blocküberlappung, müssen dabei so ausgewählt werden, dass einerseits die Erfordernisse für eine Signalrekonstruktion ohne Aliasing-Effekt erreicht werden und dass andererseits die gewünschten Berechnungen der Gewichtungsfaktoren möglich sind.

Die adaptiven Gewichtungsfaktoren $g_i$ werden dabei gemäß einer "Spektral-Subtraktionsregel" ermittelt. Diese Regel basiert entweder auf der Periodizität des Eingangssignals oder auf den Kurzzeit-Energien der Teilbandsignale. Daher ist es üblich, für die Gewichtungsfaktoren-Berechnungen analytische Teilbandsignale und komplexe Bandpass-Impulsantworten $h_i(k)$ einzuführen:

$$\hat{h}_i(k) = h(k) \cdot e^{\pm j\frac{2\pi}{2N}i(k-k_0)} \quad ; i=0,1,...2N\text{-}1 \tag{16}$$

Die komplexen Teilband-Abtastwerte

$$\begin{aligned}
\tilde{y}_i(k') &= \sum_{\kappa=0}^{n-1} x(k'-\kappa) \cdot \hat{h}_i(\kappa) \\
&= \sum_{\kappa=0}^{n-1} x(k'-\kappa) \cdot h(\kappa) \cdot e^{\pm j\frac{2\pi}{2N}i(\kappa-k_0)} \\
&= e^{\mp j\frac{2\pi}{2N}ik_0} \cdot \sum_{\kappa=0}^{n-1} x(k'-\kappa) \cdot h(\kappa) \cdot e^{\pm j\frac{2\pi}{2N}i\kappa}
\end{aligned} \tag{17}$$

werden dabei zu bestimmten Zeitschritten k' berechnet, welche einzig auf Basis der Notwendigkeiten für die Gewichtungsfaktoren-Berechnung bestimmt werden, wobei jedoch die reduzierten Bandbreiten der Einhüllenden der Teilband-Signale zu berücksichtigen sind.

Die dritte Zeile der Gleichung (17) sieht abgesehen von der oberen Summengrenze n-1 genau wie der IDFT/DFT-Ausdruck des zeitlich umgedrehten Eingangssignals x(k) multipliziert mit der Prototyp-Tiefpass-Impulsantwort h (k) aus. Die Impulsantwort wird dabei als das effektive Fenster zur Auswahl der Abtastwerte für einen Signalblock

$$x(k'), x(k'\text{-}1), x(k'\text{-}2),....x(k'\text{-}n + 1) \tag{18}$$

betrachtet.

Ohne Verlust an Allgemeinheit kann dabei im Folgenden der Spezialfall n=2N betrachtet werden. Da die Gewichtungsfaktoren $g_i$ als Funktionen der Kurzzeitenergien ermittelt werden, die auf Basis des Betrags der Abtastwerte bzw. der Einhüllenden der Teilbänder berechnet werden, ist das +/-Zeichen in der letzten Zeile von Gleichung (17) nicht relevant. Der Betrag der Abtastwerte kann somit durch eine Diskrete Fourier-Transformation bzw. Fast-Fourier-Transformation gemäß der Gleichung

$$\left|\widetilde{y}_i\left(k'\right)\right| = \left|\text{DFT}\left\{x(\kappa)\cdot h\left(k'-\kappa\right)\right\}\right| \qquad (19)$$

berechnet werden.

Eine Realisierung dieses Konzepts in einer Fensterfunktionsberechnungseinrichtung 3 ist in Figur 10 schematisch dargestellt. Der Signalblock des Eingangssignals x(k) für die Diskrete Fourier-Transformation wird hier mittels einer Speicher- und Vorbearbeitungskette 13 ermittelt. Darin wird das Eingangssignal x(k) wieder mit Verzögerungselementen 14 um jeweils einen Abtastwert verschoben. D. h. die Fensterfunktionsberechnungseinrichtung 3 weist hier eine Verzögerungskette auf, welche der Verzögerungskette im äquivalenten Zeitbereichsfilter selbst entspricht. In dem in Figur 10 dargestellten Ausführungsbeispiel ist folglich eine Fensterfunktionsberechnungseinrichtung 3 für ein äquivalentes Zeitbereichsfilter 2 mit gleichförmiger Frequenzauflösung gezeigt.
Für ein Filter mit ungleichförmiger Frequenzauflösung könnte auch hier wieder eine Speicherkette entsprechend Figur 6 gewählt werden.

Die Signalwerte x(k), k=0,...,2N-1 dieses Signalblocks werden dann mit dem entsprechenden Funktionswert der Prototyp-Tiefpass-Impulsantwort h(k) multipliziert und dann auf die 2N Eingänge einer Zeit-/Spektral-Transformationseinrichtung 10 gegeben. Die Eingangssignale der Fensterfunktionsberechnungseinrichtung 3 bzw. der Zeit-/Spektral-Transformationseinrichtung 10 sind folglich die gewichteten Zustandsvariablen des Zeitbereichsfilters 2. In dieser Einrichtung werden daraus mit Hilfe der Diskreten Fourier-Transformation bzw. Fast-Fourier-Transformation entsprechend 2N Ausgangssignale $\widetilde{y}_i(k')$,i=0,1,...,2N-1 im Spektralbereich erzeugt. Diese werden dann der Gewichtungskoeffizienten-Berechnungseinrichtung 11 zugeführt, welche beispielsweise in üblicher Weise (d. h. wie bei den bekannten Analyse-Synthese-Systemen) die Gewichtungsfaktoren $g_i$, i=0,...,2N-1 erzeugt. Diese Gewichtungsfaktoren $g_i$ werden dann weiter an eine Spektralzeit-Transformationseinrichtung 12 übergeben, welche durch entsprechende Inverse Diskrete Fourier-Transformation (bzw. Inverse Fast-Fourier-Transformation) die Gewichtungskoeffizienten $g_i$ in den Zeitbereich transformiert, wobei die gewünschte Fensterfunktion w(k) entsteht.

Für Fälle, in denen die Länge der Tiefpass-Prototyp-Impulsantwort h(k) im Zeitbereichsfilter 2 kleiner ist als die Transformationslänge 2N in der Gewichtungskoeffizientberechnungseinrichtung, können die Signalblöcke einfach durch Auffüllen mit Null-Werten auf die Länge der Diskreten Fourier-Transformation erweitert werden.

Anders ist dies in Fällen, in denen die Prototyp-Tiefpass-Impulsantwort länger ist als die Transformationslänge 2N, beispielsweise die Länge n=L·2N aufweist. In diesen Fällen kann ein gefensterter Signalblock einer Länge n mittels einer sogenannten Polyphasen-Vorverarbeitung in modifizierte Sequenzen u(k',μ) der Transformationslänge 2N zerlegt werden. (z.B. P. Vary, U. Heute, W. Hess: Digitale Sprachsignalverarbeitung; Teubner Verlag 1998, S. 107-110) Hierzu muss die Summe in Gleichung (17) durch die Substitution

$$\kappa = \nu \cdot 2N + \mu; \; \nu = 0,1,...,L\text{-}1; \; \mu = 0,1,...,2N\text{-}1 \qquad (20)$$

in eine Doppelsumme entsprechend

$$\left|\widetilde{y}_i\left(k'\right)\right| = \left|\sum_{\kappa=0}^{n-1} x\left(k'-\kappa\right)\cdot h(\kappa)\cdot e^{-j\frac{2\pi}{2N}i\kappa}\right|$$

$$= \left|\sum_{\mu=0}^{2N-1}\sum_{\nu=0}^{L-1} x\left(k'-\left(\nu\cdot 2N+\mu\right)\right)\cdot h\left(\nu\cdot 2N+\mu\right)\cdot e^{-j\frac{2\pi}{2N}i\left(\nu\cdot 2N+\mu\right)}\right| \qquad (21)$$

$$= \left|\sum_{\mu=0}^{2N-1} u\left(k',\mu\right)\cdot e^{-j\frac{2\pi}{2N}i\mu}\right|$$

zerlegt werden. Das Endresultat ist dann eine Diskrete Fourier-Transformation der neuen Sequenz u(k',μ), welche

letztendlich eine Überlagerung benachbarter Segmente der Länge 2N von gewichteten Signal-Abtastwerten ist.

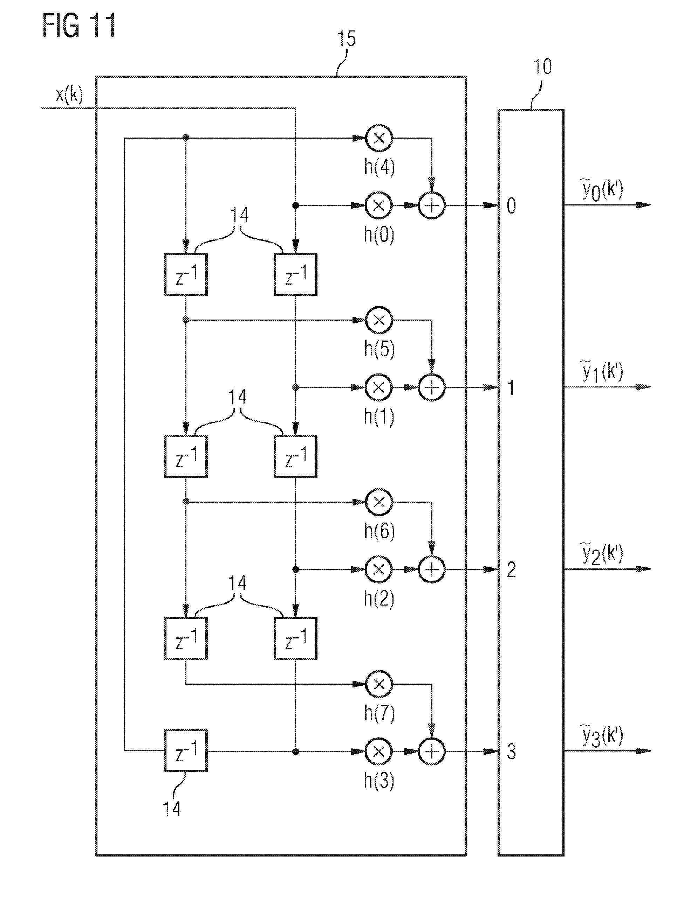

Für das konkrete Beispiel M=2N=4 und n=8 ist dies in Figur 11 dargestellt. Hier kann die Zeit-/Spektral-Transformationseinrichtung 10 nur eine Diskrete Fourier-Transformation der Länge M=4 durchführen. Dementsprechend weist die Zeit-/Spektral-Transformationseinrichtung 10 nur vier Eingänge auf. Andererseits müssen Signalabschnitte der Länge 8 verarbeitet werden. Daher ist hier die Speicher- und Vorbearbeitungskette 15 so aufgebaut, dass der fünfte Eingangswert x(4)·h(4) am ersten Eingang der Zeit-Spektral-Transformationseinrichtung 10 mit dem ersten Eingangswert x(0)·h(0) überlagert wird und der sechste Eingangswert x(5) · h(5) mit dem zweiten Eingangswert x(1) · h (1) usw. Dies zeigt, dass es ohne weiteres möglich ist, Filterlängen aufzubauen, die größer sind als die verwendete Transformation. Durch einen solchen Aufbau wird ein erheblicher Aufwand bei der Koeffizientenberechnung eingespart, was wiederum die Berechnungszeiten verkürzt.

Es ist zu beachten, dass die Diskrete Fourier-Transformation in den Figuren 10 und 11 dazu dient, Werte für den realen und den Imaginärteil der analytischen Teilbandsignale zu ermitteln. Der Realteil ist dabei identisch zu den Teilbandsignalen $y_i$ des Referenzsystems an den unterabgetasteten Zeitschritten k', wobei der Imaginärteil eine Näherung der Hilbert-Transformation $\hat{y}_i$ des Realteils ist. Daher gilt:

$$\tilde{y}_i(k') = \tilde{y}_{i,R}(k') + j\tilde{y}_{i,I}(k')$$
$$= y_i(k') + j\hat{y}_i(k) \qquad (22)$$

Wie bei den üblichen Spektralsubtraktionsregeln (z.B. Y. Ephraim, D. Malah: Speech Enhancement using a Minimum Mean-Square Error Short Time Spectral Amplitude Estimator. IEEE Transactions Acoustics, Speech, and Signal Processing, Vol. 32, no 6, S. 1109-1121, Dezember 1984). können die Gewichtungsfaktoren jeweils als Quadrat des Betrags der Teilband-Signalwerte berechnet werden:

$$g_i = f\left(\left|\tilde{y}_i(k')\right|^2\right) = f\left(y_i^2(k') + \hat{y}_i^2(k')\right) \qquad (23)$$

Aufgrund des Mittelungsprozesses, welcher in der entsprechenden Berechnung inhärent durchgeführt wird, können entsprechende Gewichtungsfaktoren gemäß

$$\tilde{g}_i = f\left(y_i^2(k')\right)$$

allein als Funktion des Realteils berechnet werden. Daher können die komplexwertigen Diskreten Fourier-Transformationen in den Figuren 10 und 11 ebenso durch die entsprechenden realwertigen Diskreten Cosinus-Transformationen ersetzt werden.

Die erfindungsgemäße Filterstruktur erlaubt folglich insgesamt auf einfache Weise eine beliebige spektrale Signalmodifikationen mit gleichförmiger oder nicht gleichförmiger Spektralauflösung und mit festen oder adaptiven Gewichtungsfaktoren der Teilbandsignale. Das gewünschte Verhalten wird dabei einzig und allein mit einem einzelnen äquivalenten Zeitbereichsfilter mit einer Impulsantwort erreicht, welche das Produkt aus einer Prototyp-Tiefpass-Impulsantwort mit einer ggf. zeitvarianten Fensterfunktion ist. Die Gewichtungsfaktoren können dabei vorzugsweise mit einer reduzierten Taktrate innerhalb der Frequenzbandbereiche mit Hilfe von Diskreter Fourier-Transformation oder Diskreter Cosinus-Transformation der gewichteten Zustandsvariablen des Zeitbereichsfilters berechnet werden. Dies ist ein ganz erheblicher Vorteil, da die Bedingungen für die Signalrekonstruktion wie die spektrale Auflösung, die Verzögerung oder Aliasing-Effekte sowie die Gewichtungsfaktorenberechung, d. h. die zeitliche Auflösung entkoppelt sind.

Die in den Figuren schematisch dargestellten (Teil-)Filter-Systeme lassen sich grundsätzlich in Form von diskreten Schaltungsaufbauten realisieren. Besonders bevorzugt findet aber eine Realisierung mittels softwareprogrammierter Signalprozessoren bzw. in Form von ASCIs statt. Ein solcher Aufbau ist erheblich kostengünstiger. Darüber hinaus ist eine solche Realisierung auch platzsparender und hat gegenüber einem diskreten Schaltungsaufbau keinerlei Nachteile.

Abschließend wird noch einmal darauf hingewiesen, dass es sich bei den in den Figuren konkret dargestellten und zuvor beschriebenen Verfahren und Filteraufbauten um Ausführungsbeispiele handelt, die vom Fachmann modifiziert werden können, ohne den Rahmen der Erfindung zu verlassen. So könnte z. B. ein adaptiver Filter auch so realisiert werden, dass die Eingangswerte für die Gewichtungsfaktoren-Berechnungseinrichtung am Ausgang der Verzögerungskette des äquivalenten Zeitbereichsfilter abgegriffen werden. Somit könnte eine eigene Verzögerungskette für die Gewichtungsfaktoren-Berechnungseinrichtung eingespart werden.

**Patentansprüche**

1. Verfahren zur spektralen Modifikation eines digitalen Signals (x(k)), bei dem das digitale Signal (x(k))mit einem äquivalenten Zeitbereichsfilter mit einer effektiven Summenimpulsantwort gefiltert wird, indem das digitale Signal durch eine Verzögerungskette (8, 9) mit einer Anzahl von Verzögerungsstufen (4, 5) geleitet wird und an der Verzögerungskette (8, 9) abgegriffene Signalanteile durch eine Filtereinheit (6) mit einer gewichteten Tiefpass-Prototyp-Impulsantwort (h(0),...,h(k),...,h(n-1)) geleitet werden und die Signalanteile anschließend wieder aufsummiert werden.

2. Verfahren nach Anspruch 1, **dadurch gekennzeichnet, dass** die Tiefpass-Prototyp-Impulsantwort ((h(0),...,h(k),...,h(n-1)) mit einer Fensterfunktion (w (0),...,w (k),...,w (n-1)) gewichtet wird.

3. Verfahren nach Anspruch 2, **dadurch gekennzeichnet, dass** die Fensterfunktion (w (0),...,w (k),...,w (n-1)) gemäß einer vorgegeben Regel aus dem zu modifizierenden digitalen Signal (x(k)) und/oder einem externen Signal gewonnen wird.

4. Verfahren nach Anspruch 3, **dadurch gekennzeichnet, dass** das zu modifizierende digitale Signal (x(k)) und/oder das externe Signal in den Spektralbereich transformiert wird und im Spektralbereich daraus Gewichtungskoeffizienten ($g_0$, ..., $g_N$, ..., $g_{2N-1}$) berechnet werden, und diese Gewichtungskoeffizienten ($g_0$,...,$g_N$,...,$gz_{N-1}$) zur Ermittlung der Fensterfunktion (w (0),...,w (k),...,w (n-1)) vom Spektralbereich in den Zeitbereich transformiert werden.

5. Verfahren nach Anspruch 3 oder 4, **dadurch gekennzeichnet, dass** bei der Ermittlung der Fensterfunktion (w (0),...,w (k),...,w (n-1)) ein mittels einer Verzögerungskette gebildeter, aktuell im Filter (6) bearbeiteter Signalblock des Eingangssignals (x(k)) und/oder eine Anzahl vorhergehender Signalblöcke berücksichtigt werden.

6. Verfahren nach Anspruch 4 oder 5, **dadurch gekennzeichnet, dass** die Gewichtungskoeffizienten ($g_0$,..., $g_N$,..., $9_{2N-1}$) zur Ermittlung der Fensterfunktion (w(0) ,...,w(k) ,...,w(n-1)) mittels einer Inversen Diskreten Fourier-Transformation oder einer Inversen Diskreten Cosinus-Transformation vom Spektralbereich in den Zeitbereich transformiert werden.

7. Verfahren nach einem der Ansprüche 1 bis 6, **dadurch gekennzeichnet, dass** die Verzögerungsstufen (4) das zu modifizierende digitale Signal jeweils um eine Abtastperiode des zu modifizierenden digitalen Signals verzögert.

8. Verfahren nach einem der Ansprüche 1 bis 6, **dadurch gekennzeichnet, dass** das zu modifizierende digitale Signal (x(k)) mit einem äquivalenten Zeitbereichsfilter mit ungleichförmiger Frequenzauflösung gefiltert wird.

9. Verfahren nach Anspruch 8, **dadurch gekennzeichnet, dass** zumindest ein Teil der Verzögerungsstufen (5) eine Allpass-Transfer-Funktion aufweist.

10. Filterbank (1) zur spektralen Modifikation eines digitalen Signals mit einem äquivalenten Zeitbereichsfilter (2) zum Filtern des digitalen Signals mit einer effektiven Summenimpulsantwort, umfassend

- eine Verzögerungskette (8, 9) mit einer Anzahl von Verzögerungsstufen, um das das zu modifizierende digitale Signal (x(k)) stufenweise zu verzögern,
- eine der Verzögerungskette (8, 9) nachgeschaltete Filtereinheit (6), welche an der Verzögerungskette (8, 9) abgegriffene Signalanteile mit einer gewichteten Tiefpass-Prototyp-Impulsantwort (h(0),...,h(k),...,h(n-1)) filtert,
- und eine Summiereinrichtung (7), um aus den gefilterten Signalanteilen ein Ausgangssignal zu erzeugen.

11. Filterbank nach Anspruch 10, **dadurch gekennzeichnet, dass** die Filter (6) jeweils Mittel aufweisen, um die Tiefpass-Prototyp-Impulsantwort (h(0),...,h(k),...,h(n-1)) mit einer Fensterfunktion (w(0),...,w(k),...,w(n-1)) zu gewichten.

**12.** Filterbank nach Anspruch 11, **gekennzeichnet durch** eine Fensterfunktions-Berechnungseinrichtung (3), welche gemäß einer vorgegeben Regel aus dem zu modifizierenden digitalen Signal (x(k)) und/oder einem externen Signal die Fensterfunktion (w(0),...,w(k),...,w(n-1)) ermittelt.

**13.** Filterbank nach Anspruch 12, **dadurch gekennzeichnet, dass** die Fensterfunktions-Berechnungseinrichtung (3) eine

- Zeit-/Spektraltransformationseinrichtung (10), um das zu modifizierende digitale Signal (x(k)) und/oder das externe Signal in den Spektralbereich zu transformieren,
- eine Gewichtungskoeffizienten-Berechnungseinrichtung (11), um auf Basis des transformierten zu modifizierenden digitalen Signals und/oder externen Signals Gewichtungskoeffizienten ($g_0,..., g_N,..., g_{2N-1}$) zu gewinnen,
- und eine Spektral-/Zeittransformationseinrichtung (12) aufweist, um zur Ermittlung der Fensterfunktion (w(0),...,w(k),...,w(n-1) ) die Gewichtungskoeffizienten ($g_0,..., g_N,..., g_{2N-1}$) vom Spektralbereich in den Zeitbereich zu transformieren.

**14.** Filterbank nach Anspruch 12 oder 13, **dadurch gekennzeichnet, dass** die Fensterfunktions-Berechnungseinrichtung (3) eine der Verzögerungskette (8, 9) des äquivalenten Zeitbereichsfilters (2) entsprechende Verzögerungskette für das digitale Signal x(k) aufweist.

**15.** Digitale Signalverarbeitungseinrichtung mit einer Filterbank (1) nach einem der Ansprüche 10 bis 14.

**16.** Mobilfunkgerät mit einer Filterbank (1) nach einem der Ansprüche 12 bis 14.

**17.** Mobilfunk-Netzkomponente mit einer Filterbank (1) nach einem der Ansprüche 12 bis 14.

## FIG 1 Stand der Technik

$x(k)$ → $h_0(k)$ → $y_0(k)$ → $\oplus$ → $g_0$ → $\oplus$ → $y(k)$

→ $h_1(k)$ → $y_1(k)$ → $\oplus$ → $g_1$

→ $h_i(k)$ → $y_i(k)$ → $\oplus$ → $g_i$

→ $h_N(k)$ → $y_N(k)$ → $\oplus$ → $g_N$

$g_0, \dots g_N$

$g_i,\ i = 0,1,\dots N$

## FIG 2 Stand der Technik

$x(k)$ → Spektral-Analyse → $X_0$, $X_1$, $X_2$, $X_3$, $\dots$, $X_{M-1}$ → "Spektrale Substraktion"  $\hat{S}_\mu(k) = \overline{X}_\mu(k) \cdot H_\mu(k)$ → $\hat{S}_0$, $\hat{S}_1$, $\hat{S}_2$, $\hat{S}_3$, $\dots$, $\hat{S}_{M-1}$ → Spektral-Synthese → $y(k)$

FIG 3

2

1

x(k)

h(k)·w(k)

y(k)

10

12

3

11

FIG 4

$|H_0| = |H|$

i = 0

$-\pi$

$\Omega$

$\pi$

$|H_1|$

i = 1

$-\pi$

$-\dfrac{\pi}{N}$

$\dfrac{\pi}{N}$

$\pi$

$|H_i|$

i

$-\pi$

$-i \cdot \dfrac{\pi}{N}$

$i \cdot \dfrac{\pi}{N}$

$\pi$

$|H_N|$

i = N

$-\pi$

$\Omega$

$\pi$

FIG 5

x(k)

x$_0$
h(0)    w(0)

x$_1$
h(1)    w(1)

x$_\kappa$
h($\kappa$)    w($\kappa$)

x$_{n-1}$
h(n-1)    w(n-1)

y(k)

z$^{-1}$    4
z$^{-1}$    4
4
z$^{-1}$    4

8    7    2    6

FIG 6

x(k)

x$_0$
h(0)    w(0)

x$_1$
h(1)    w(1)

x$_\kappa$
h($\kappa$)    w($\kappa$)

x$_{n-1}$
h(n-1)    w(n-1)

y(k)

H$_A$(z)    5
H$_A$(z)    5
5
H$_A$(z)    5

2    9    7    6

FIG 7

FIG 9

## FIG 8

FIG 10

## FIG 11